(19) Europäisches Patentamt / European Patent Office / Office européen des brevets

(11) **EP 4 592 691 B1**

(12) **EUROPEAN PATENT SPECIFICATION**

(45) Date of publication and mention
of the grant of the patent:
**04.03.2026  Bulletin 2026/10**

(21) Application number: **24154150.7**

(22) Date of filing: **26.01.2024**

(51) International Patent Classification (IPC):
**G01R 27/28** (2006.01)    **G01R 35/00** (2006.01)

(52) Cooperative Patent Classification (CPC):
**G01R 35/005; G01R 27/28**

(54) **CALIBRATION METHOD AND CALIBRATION SYSTEM**

KALIBRIERVERFAHREN UND KALIBRIERSYSTEM

PROCÉDÉ D'ÉTALONNAGE ET SYSTÈME D'ÉTALONNAGE

(84) Designated Contracting States:
**AL AT BE BG CY CZ DE DK EE ES FI FR GB GR
HR HU IS IT LT LU LV MC ME MK MT NL NO PL PT
RO RS SE SI SK SM TR**

(43) Date of publication of application:
**30.07.2025  Bulletin 2025/31**

(73) Proprietor: **Rohde & Schwarz GmbH & Co. KG
81671 München (DE)**

(72) Inventor: **Ramian, Florian
81671 München (DE)**

(74) Representative: **Novagraaf Group
Chemin de l'Echo 3
1213 Onex (CH)**

(56) References cited:
**US-A1- 2008 018 342    US-A1- 2017 160 369
US-B1- 6 836 743**

• ZIMMERMANNS MARC ET AL: "A self-calibration
technique for microwave multiport
measurements", 2017 47TH EUROPEAN
MICROWAVE CONFERENCE (EUMC),
EUROPEAN MICROWAVE ASSOCIATION, 10
October 2017 (2017-10-10), pages 739 - 742,
XP033284742, DOI: 10.23919/
EUMC.2017.8230953

**Description**

The invention generally relates to a calibration method of calibrating a test instrument. The invention further relates to a calibration system.

In order to perform accurate measurements on a device under test, the test setup comprising a test instrument has to be calibrated, thereby ensuring a maximum accuracy of the measurements conducted.

For example, one calibration technique known in the state of the art is a so-called OSM-calibration, wherein three different calibration standards ("open", "short", and "matched") are consecutively connected to the test instrument and corresponding reflection measurements are performed, respectively. The OSM-calibration is also known as SOL-calibration ("short", "open", "load").

A calibration method of this kind is known from US 2017/160369 A1.

If the test instrument comprises more than one port that is to be connected to the device under test, additional relative measurements between the ports have to be performed, for example by adding a "through" calibration measurement (TOSM-method) or an "unknown" calibration measurement (UOSM-method). The TOSM-method is also known as SOLT-method ("short", "open", "load", "through").

To fully characterize a test instrument, the relative measurements have to be performed for each pair of ports. Thus, the number of measurements necessary grows rapidly with the number of ports.

The object of the present invention is to provide a calibration method and system that allow for a full characterization of each port with a reduced number of measurements.

According to the invention, the problem is solved by a calibration method of calibrating a test instrument. The test instrument comprises at least one port, at least one signal analysis module, and at least one signal generator module. The at least one signal analysis module and the at least one signal generator module are each connected to the at least one port. The calibration method comprises the steps of:

- consecutively connecting a set of calibration standards to the at least one port and performing a calibration measurement for each calibration standard connected, thereby obtaining a first set of measurement data;

- determining, based on a multi-port error model and the first set of measurement data, a plurality of error terms of the multi-port error model, wherein the error terms describe transmissivity and reflectivity properties of at least the at least one port, and wherein at least one of the error terms comprises a product of two error parameters;

- connecting an additional calibration standard to the at least one port, wherein the additional calibration standard is a signal source with known properties or a signal sink with known properties;

- performing a calibration measurement with the additional calibration standard connected, thereby obtaining a second set of measurement data; and

- determining the two error parameters based on the second set of measurement data.

Therein and in the following, the terms "error term" and "error parameter" are understood to denote parameters of the multi-port error model describing transmissivity and reflectivity properties of a portion of the measurement setup including the port.

Further, the term "module" is understood to describe suitable hardware, suitable software, or a combination of hardware and software that is configured to have a certain functionality.

The hardware may, inter alia, comprise a CPU, a GPU, an FPGA, an ASIC, or other types of electronic circuitry.

Based on the determined error terms and error parameters, operational parameters of the test instrument can be adjusted, i.e. the test instrument can be calibrated with respect to the at least one port.

In fact, the operational parameters may be corrected in time domain or in frequency domain.

With previously known calibration methods, the at least one error term comprising the product of the two error parameters can only be determined as a whole, while the individual error parameters cannot be determined based on measurements on the at least one port alone.

The calibration method according to the present invention is based on the idea to provide an additional calibration standard with known properties.

Performing the additional calibration measurement on the additional calibration standard allows to disentangle the product of the two error parameters, such that the individual error parameters can be determined.

This allows to determine all necessary parameters of the multi-port error model based on measurements conducted on the at least one port alone.

In other words, the at least one port of the test instrument can be fully characterized based on measurements conducted on the at least one port alone, i.e. independent of other ports of the test instrument.

Thus, the necessary number of measurements is reduced if the test instrument comprises a plurality of ports.

However, it is to be understood that the calibration method according to the present invention can likewise be applied to test instruments with only one port. In this case, the calibration method according to the present invention allows for a full characterization of the single port.

In fact, it has turned out that the calibration method according to the present invention is also suitable for calibrating vector network analyzers, particularly also for modulated vector network analyzers.

The calibration method may comprise the step of providing the test instrument comprising the at least one port, the at least one signal analysis module, and the at least one signal generator module, wherein the at least one signal analysis module and the at least one signal generator module are each connected to the at least one port.

Optionally, the calibration method may comprise the step of connecting the at least one signal analysis module and/or the at least one signal generator module to the at least one port, particularly if the at least one signal analysis module and/or the at least one signal generator module are/is not connected to the at least one port in an initial state of the test instrument.

According to an aspect of the present invention, the calibration standards are connected to the at least one port at a reference plane. Accordingly, the first set of measurement data and the second set of measurement data are obtained with respect to the reference plane, which may include a connection between the at least one port and reference plane, such as a cable. Thus, the multi-port error model describes transmissivity and reflectivity properties of a portion of the measurement setup including the port and the reference plane, particularly including a cable connecting the at least one port to the reference plane.

In fact, the reference plane may correspond to the plane at which a device under test is to be connected to the at least one port.

In an embodiment of the present invention, a cable is connected to the at least one port, wherein the reference plane is located at an end of the cable facing away from the at least one port. Thus, the multi-port error model describes transmissivity and reflectivity properties of a portion of the measurement setup including the port, the cable, and the reference plane. This way, the accuracy of the calibration or rather of subsequent measurements on a device under test can be enhanced, as connections between the test instrument and the device under test, namely the cable, are incorporated into the calibration.

According to another aspect of the present invention, the product of two error parameters comprises a first error parameter and a second error parameter, wherein the first error parameter is determined directly based on the second set of measurement data, and wherein the second error parameter is calculated based on the determined product of the two error parameters and based on the first error parameter. In other words, one of the two error parameters can be measured directly, while the other one of the two error parameters can be then be determined or rather calculated, as the product of the two error parameters has already been determined based on the first set of measurement data.

It is noted that it is in principle also possible to conduct another measurement with another known calibration standard, such that both error parameters can be measured directly. However, this requires an additional measurement step.

A further aspect of the present invention provides that a mismatch of the additional calibration standard is corrected based on the first set of measurement data. In fact, an impedance mismatch between the additional calibration standard and the reference plane may be corrected based on the first set of measurement data. Thus, the second set of measurement data can be determined with enhanced accuracy, as the mismatch is corrected based on the first set of measurement data.

In a further embodiment of the present invention, the test instrument comprises at least one directional coupler, wherein the at least one signal analysis module and the at least one signal generator module are connected to the at least one port by the at least one directional coupler. More precisely, each port is connected to at least one signal generator module and to at least one signal analysis module via the at least one directional coupler. This way, all necessary calibration measurements can be performed on the at least one port independent of other ports in a particularly efficient way.

The multi-port error model may be an n-term error model, particularly a fourterm error model. Accordingly, the multi-port error model comprises n error parameters that need to be determined in order to calibrate the test instrument, i.e. the error terms comprise a total of n error parameters.

Therein, n is an integer greater than 1, particularly equal to or greater than 4.

However, it is to be understood that any other suitable error model may be used, for example a 12-term error model.

Particularly, the multi-port error model is a two-port error model. Therein, one port of the error model may be associated with the signal generator module or the signal analysis module, while the other port of the error model may be associated with the reference plane. The error model describes transmissivity and reflectivity properties within a portion of the test system modeled by the error model, namely a portion of the test system between the signal generator module or the signal analysis module and the reference plane.

According to an aspect of the present invention, exactly one port of the test instrument is calibrated at a time. As already explained above, the calibration method according to the present invention allows to calibrate each port independent of other ports. Thus, different ports of the test instrument can be calibrated consecutively.

In an embodiment of the present invention, the additional calibration standard is established as a signal generator, a comb generator, an oscilloscope, or an analog-to-digital converter. More precisely, the additional calibration standard may be established as a signal generator with known properties, a comb generator with known properties, an oscilloscope with known properties, or an analog-to-digital converter with known properties.

However, it is to be understood that any other suitable type of additional calibration standard may be used.

According to another aspect of the present invention, the individual calibration standards of the set of calibration standards are provided in a calibration device having a housing, wherein the calibration device further comprises a switching module and a connecting port, and wherein the switching module is configured to selectively connect one of the calibration standards to the connecting port. Thus, a particularly convenient way of obtaining the first set of measurement data is provided, as the calibration standards can simply be connected to the at least one port of the test instrument by connecting the calibration standards to the connecting port consecutively via the switching module. Thus, it is not necessary to change the measurement setup for performing the calibration measurements on the different calibration standards.

Therein, the connecting port may be connected to the at least one port of the test instrument, for example by a cable.

For example, the set of calibration standards may comprises three different calibration standards, particularly wherein the three different calibration standards may be provided in the housing of the calibration device. For example, the three different calibration standards may be "open", "short", and "matched. However, any other suitable set of calibration standards may be used.

In an embodiment of the present invention, the additional calibration standard may be provided in the housing. The switching module may be configured to selectively connect one of the calibration standards or the additional calibration standard to the connecting port. Thus, a particularly convenient way of obtaining the first set of measurement data and the second set of measurement data is provided, as the calibration standards and the additional calibration standard can simply be connected to the at least one port of the test instrument by connecting the calibration standards to the connecting port consecutively via the switching module. Thus, it is not necessary to change the measurement setup for performing the calibration measurements on the different calibration standards and on the additional calibration standard.

Alternatively, the additional calibration standard may be provided separately from the calibration device, wherein the calibration device comprises a further connecting port, and wherein the switching module is configured to selectively connect one of the calibration standards or the further connecting port to the connecting port. Thus, the additional calibration standard being provided separately from the calibration device may be connected to the further connecting port, for example by a cable, such that the switching module can selectively connect one of the calibration standards or the additional calibration standard to the connecting port and thus to the test instrument. Providing the additional calibration standard outside of the housing of the calibration device is particularly advantageous if the additional calibration standard generates a significant amount of heat.

Particularly, the test instrument is a vector network analyzer, a signal generator, particularly a vector signal generator, or a signal analyzer, particularly a vector signal analyzer. For example, the test instrument may be a modulated vector network analyzer.

If the test instrument is a signal analyzer, particularly a vector signal analyzer, the test instrument may still comprise the signal generator module. The signal generator module may serve as a "helper" module for performing the calibration method described above.

If the test instrument is a signal generator, particularly a vector signal generator, the test instrument may still comprise the signal analysis module. The signal analysis module may serve as a "helper" module for performing the calibration method described above.

However, it is to be understood that the calibration method described above can be applied to any other test instrument having at least one port, for example to oscilloscopes, spectrum analyzers, etc.

According to the present invention, the problem further is solved by a calibration system. The calibration system comprises a test instrument, a set of calibration standards, and an additional calibration standard, wherein the calibration system is configured to perform the calibration method according to any one of the variants described above.

Regarding the advantages and further properties of the calibration system, reference is made to the explanations given above with respect to the calibration method, which also hold for the calibration system and vice versa.

The foregoing aspects and many of the attendant advantages of the claimed subject matter will become more readily appreciated as the same become better understood by reference to the following detailed description, when taken in conjunction with the accompanying drawings, wherein:

- Figure 1 schematically shows a first variant of a calibration system according to the present invention;

- Figure 2 schematically shows a second variant of a calibration system according to the present invention;

- Figure 3 shows a flow chart of a calibration method according to the present invention;

- Figure 4 shows a first variant of a multi-port error model; and

- Figure 5 shows a second variant of a multi-port error model.

DETAILED DESCRIPTION

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

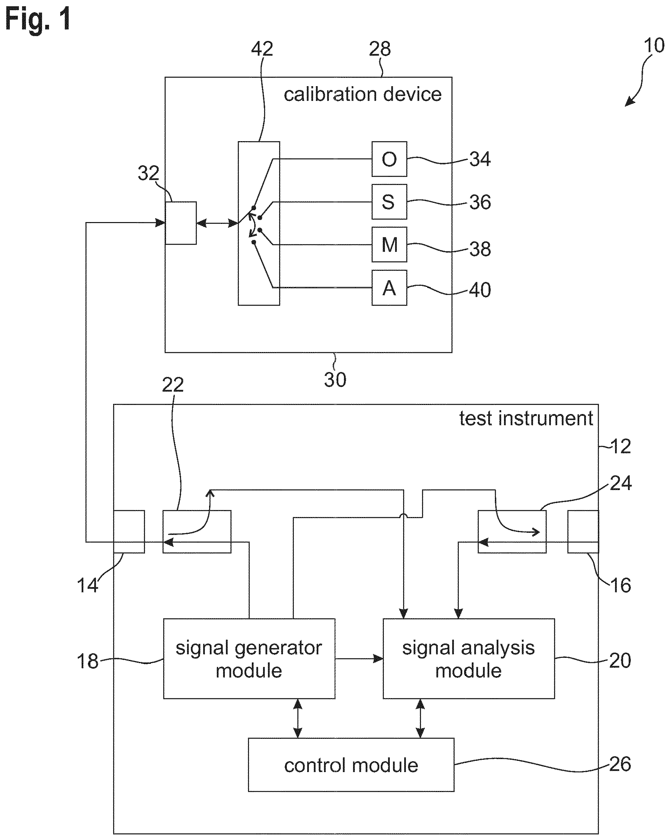

Figure 1 schematically shows a calibration system 10 for calibrating a test instrument 12.

In the exemplary embodiment shown in Figure 1, the test instrument 12 may be established as a vector network analyzer comprising a first port 14 and a second port 16.

For example, the test instrument 12 may be a modulated vector network analyzer.

However, it is to be understood that the explanations given hereinafter likewise apply to other types of test instruments that may have the same or a different number of ports.

For example, the test instrument 12 may be a signal analyzer, a vector signal analyzer, a signal generator, a vector signal generator, a spectrum analyzer, or an oscilloscope.

Without restriction of generality, the exemplary embodiment of the test instrument 12 shown in Figure 1 is described hereinafter.

The test instrument 12 comprises a signal generator module 18 and a signal analysis module 20.

The signal generator module 18 is configured to generate a test signal that can be applied to a device under test via the first port 14.

Particularly, the signal generator module 18 may be or comprise a vector signal generator.

The signal analysis module 20 is configured to receive a corresponding processed signal from the device under test via the second port 16, and to analyze the processed signal in order to assess a performance of the device under test.

Particularly, the signal analysis module 20 may be or comprise a vector signal analyzer.

Therein, the signal generator module 18 and the signal analysis module 20 are each connected to the first port 14 via a first directional coupler 22.

The first directional coupler 22 is configured to transmit a forward-travelling signal from the signal generator module 18 to the first port 14.

The first directional coupler 22 is further configured to transmit a backward-travelling signal from the first port 14 to the signal analysis module 20.

Moreover, the signal generator module 18 and the signal analysis module 20 are each connected to the second port 16 via a second directional coupler 24.

The second directional coupler 24 is configured to transmit a forward-travelling signal from the second port 16 to the signal analysis module 20.

The second directional coupler 24 is further configured to transmit a backward-travelling signal from the signal generator module 18 to the second port 16.

The test instrument 12 further comprises a control module 26 that is configured to control the signal generator module 18 and/or the signal analysis module 20.

More precisely, the control module 26 may be configured to set operational parameters of the signal generator module 18 and/or of the signal analysis module 20, for example frequency ranges, a bandwidth, a sampling rate, filter coefficients, etc.

The calibration system 10 further comprises a calibration device 28 that is provided separately from the test instrument 12.

In fact, the calibration device 28 comprises a housing 30 that is established separately from the test instrument 12, wherein the components described hereinafter are provided in the housing 30.

The calibration device 28 comprises a connecting port 32 that is connectable to the first port 14 and/or to the second port 16 of the test instrument 12.

The calibration device 28 further comprises a set of calibration standards, wherein the set of calibration standards comprises a first calibration standard 34, a second calibration standard 36, and a third calibration standard 38.

For example, the first calibration standard 34, the second calibration standard 36, and the third calibration standard 38 may correspond to "open" ("O"), "short" ("S"), and "matched" ("M") calibration standards, respectively.

However, it is to be understood that the set of calibration standards may comprise other suitable types of calibration standards.

Moreover, an additional calibration standard 40 ("A") is provided within the housing 30 in the exemplary embodiment shown in Figure 1.

In general, the additional calibration standard 40 is a signal source with known properties or a signal sink with known properties.

For example, the additional calibration standard 40 may be established as a signal generator, a comb generator, or an analog-to-digital converter.

The calibration device 28 further comprises a switching module 42 that is connected to the connecting port 32 as well as to the calibration standards 34, 36, 38, 40.

The switching module 42 is configured to selectively connect one of the calibration standards 34, 36, 38 or the additional calibration standard 40 to the connecting port 32.

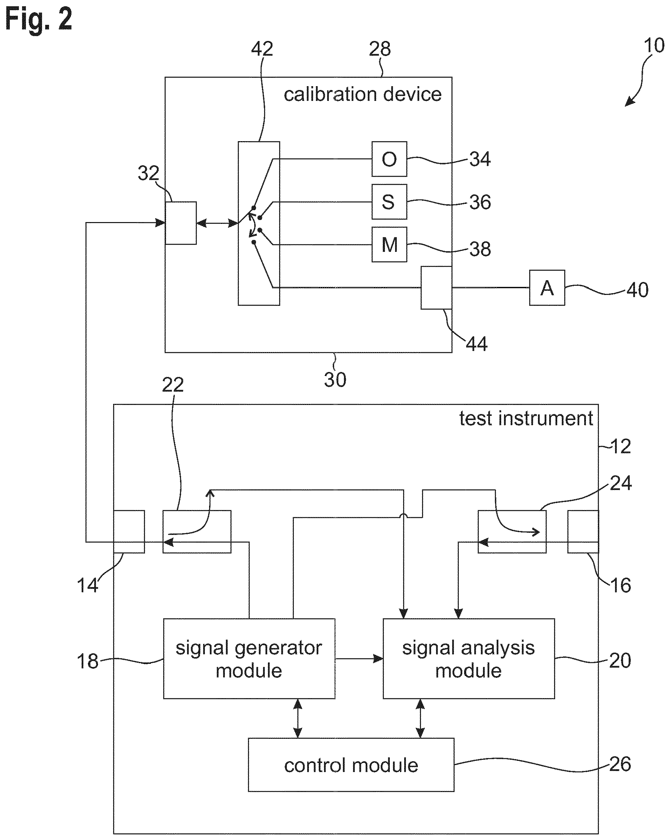

Figure 2 shows a second variant of the calibration system 10, wherein only the differences to the first variant described above are explained hereinafter.

In the variant shown in Figure 2, the additional calibration standard 40 is provided separately from the calibration device 28.

For example, the additional calibration standard 40 may be established as a signal generator, a comb generator, an oscilloscope, or an analog-to-digital converter.

The calibration device 28 comprises a further connecting port 44 that is connected to the switching module 42.

The further connecting port 44 is connectable to the additional calibration standard 40, such that the additional calibration standard can be connected to the connecting port 32 via the switching module 42 and the further connecting port 44.

The switching module 42 is configured to selectively connect one of the calibration standards 34, 36, 38 or the further connecting port 44 to the connecting port 32.

It is noted that the calibration device 28 according to any of the variants described above is optional. It is also possible to connect the individual calibration standards 34, 36, 38 and/or the additional calibration standard 40 to the test instrument 12 directly, i.e. directly via a cable.

Further, it is noted that the test instrument 12 may comprise more than one signal generator module, and/or more than one signal analysis module, and/or another number of ports.

In any case, each port is connected to at least one signal generator module, particularly to exactly one signal generator module, and to at least one signal analysis module, particularly to exactly one signal analysis module.

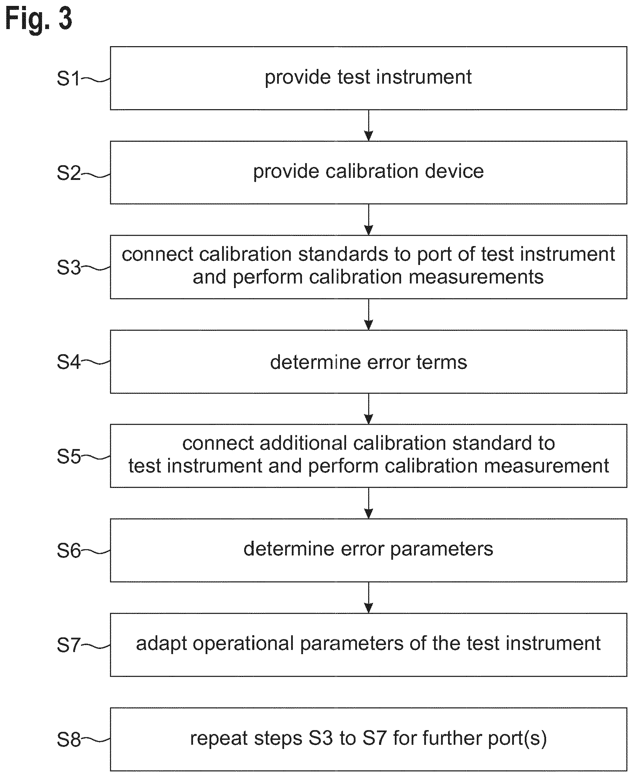

Hereinafter, a calibration method of calibrating the test instrument 12 is described with reference to Figure 3, which shows a flow chart of the calibration method.

The test instrument 12 described above is provided (step S1).

Optionally, the calibration device 28 described above is provided (step S2).

Hereinafter, it is assumed without restriction of generality that the calibration device 28 is provided. However, it is to be understood that the steps described hereinafter can also be performed without the calibration device 28 with appropriate adjustments.

The calibration standards 34, 36, 38 of the set of calibration standards are consecutively connected to the first port 14 of the test instrument, and a respective calibration measurement is performed by the signal generator module 18 and the signal analysis module 20 for each of the calibration standards 34, 36, 38 (step S3).

Particularly, a first calibration measurement is conducted with the first calibration standard 34 being connected to the first port 14.

Afterwards, a second calibration measurement is conducted with the second calibration standard 36 being connected to the first port 14.

Finally, a third calibration measurement is conducted with the third calibration standard 38 being connected to the first port 14.

In fact, the calibration measurements conducted may be reflection measurements, i.e. a test signal is generated by the signal generator module 18 and forwarded to the respective calibration standard 34, 36, 38 via the first port 14, the connecting port 32, and the switching module 42.

A signal reflected by the respective calibration standard 34, 36, 38 is forwarded to the signal analysis module 20 via the switching module 42, the connecting port 32, the first port 14, and the first directional coupler 22.

The signal analysis module 20 analyzes the respective reflected signals, thereby obtaining a first set of measurement data.

In fact, the first set of measurement data comprises measurement data on each of the calibration standards 34, 36, 38.

It is noted that starting the calibration of the test instrument 12 with the first port 14 is not necessary. Likewise, the calibration could first be performed on the second port 16 or on other ports of the test instrument 12.

A plurality of error terms of a multi-port error model are determined based on the multi-port error model and based on the first set of measurement data by the signal analysis module 20 (step S4).

In general, the error terms of the multi-port error model describe transmissivity and reflectivity properties of at least the respective port, i.e. of the first port 14 in the case described above.

More precisely, the multi-port error model comprises error terms describing the transmissivity and reflectivity properties, wherein the error terms comprise one or more error parameters each.

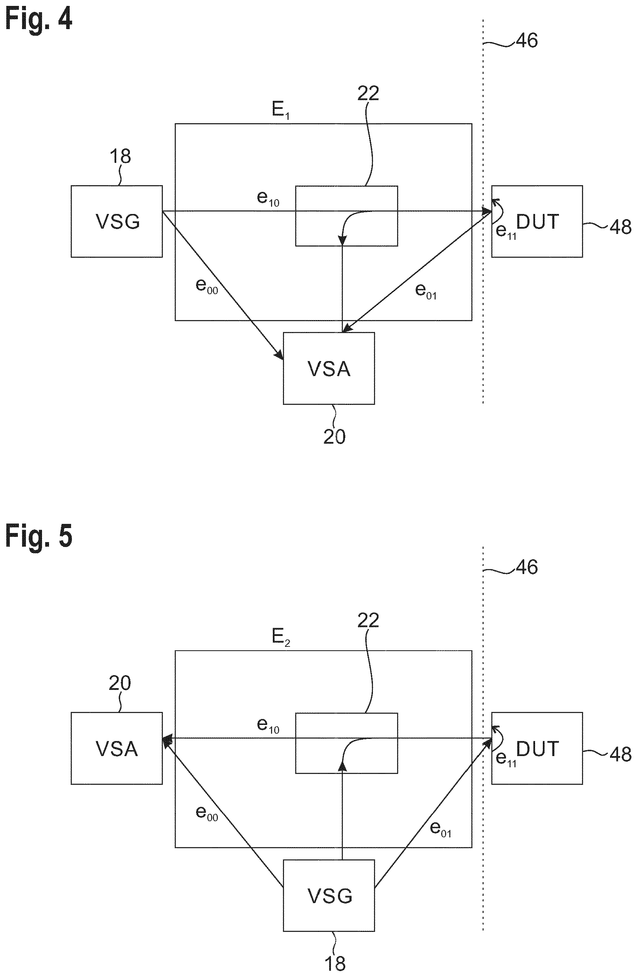

Figure 4 shows an exemplary multi-port error model. In this exemplary case, the multi-port error model is a 2-port error model with four error parameters $e_{00}$, $e_{10}$, $e_{01}$, and $e_{11}$.

However, it is to be understood that any other suitable multi-port error model may be used. In fact, the multi-port error model may be any suitable n-term error model comprising n error parameters.

The error model of Figure 4 describes a portion of the calibration system 10 between the signal generator module 18 and a reference plane 46.

As is illustrated in Figure 4, the reference plane 46 is located at the point where a device under test (DUT) 48 is to be connected to the first port 14.

During the calibration, the calibration device 28 is connected to the first port 14 at the reference plane 46.

Thus, the reference plane 46 may be at an end of a cable connecting the first port 14 and the calibration device 28, namely at the end of the cable facing away from the first port 14.

The four error parameters $e_{00}$, $e_{10}$, $e_{01}$, and $e_{11}$ describe a transmission between the signal generator module 18 and the signal analysis module 20, a transmission between the signal generator module 18 and the reference plane 46, a transmission between the reference plane 46 and the signal analysis module 20, and a reflection at the reference plane 46, respectively.

The multi-port error model can be expressed as a matrix $E_1 = \begin{pmatrix} e_{00} & e_{01} \\ e_{10} & e_{11} \end{pmatrix}$.

In this example, the error terms $e_{00}$, $e_{11}$, and $e_{01} \cdot e_{10}$ can be determined based on the first set of measurement data, i.e. one of the determined error terms comprises a product of two error parameters that cannot be determined individually based on the first set of measurement data.

The additional calibration standard 40 is connected to the first port 14, and an additional calibration measurement is performed with the additional calibration standard 40 connected to the first port 14 by the signal generator module 18 and the signal analysis module 20, thereby obtaining a second set of measurement data (step S5).

In fact, a mismatch of the additional calibration standard 40 may be corrected based on the first set of measurement data for determining the second set of measurement data.

More precisely, an impedance mismatch between the additional calibration standard 40 and the reference plane 46 may be corrected based on the first set of measurement data for determining the second set of measurement data.

The error parameters comprised in the product of error parameters are determined based on the second set of measurement data by the signal analysis module 20 (step S6).

More precisely, one of the two error parameters comprised in the product of error parameters is determined directly based on the second set of measurement data, i.e. one of the two error parameters is measured directly.

The other one of the two error parameters can then be calculated based on the determined product and based on the measured error parameter of the product.

In the exemplary multi-port error model described above, if the additional calibration standard is a signal source, the error parameter $e_{01}$ can be measured

directly, and the error parameter $e_{10}$ can then be calculated.

If the additional calibration standard is a signal sink, the error parameter $e_{10}$ can be measured directly, and the error parameter $e_{01}$ can then be calculated.

Thus, all error parameters of the multi-port error model are determined based on measurements performed with respect to the first port 14 only.

Operational parameters of the test instrument 12, particularly of the signal generator module 18 and/or of the signal analysis module 20, are adapted based on the determined error parameters by the control module 26 (step S7).

Accordingly, the test instrument 12 is calibrated with respect to the first port 14 based on the determined error parameters.

Therein, the calibration may be performed in time domain or in frequency domain.

Steps S3 to S7 described above are then repeated for the second port 16 (step S8).

The multi-port error model for calibrating the second port 16 is shown in Figure 5, and is established similarly to the multi-port error model for calibrating the first port 14 described above.

The four error parameters $e_{00}$, $e_{10}$, $e_{01}$, and $e_{11}$ describe a transmission between the signal generator module 18 and the signal analysis module 20, a transmission between the reference plane 46 and the signal analysis module 20, a transmission between the signal generator module 18 and the reference plane 46, and a reflection at the reference plane 46, respectively.

The multi-port error model can be expressed as a matrix $E_2 = \begin{pmatrix} e_{00} & e_{01} \\ e_{10} & e_{11} \end{pmatrix}$.

If the test instrument 12 comprises further ports, the further ports can be calibrated consecutively, i.e. one port may be fully calibrated at a time.

Thus, the calibration method described above enables a full calibration of all ports of the test instrument 12, wherein each port can be calibrated independent of any other ports.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

**Claims**

1. A calibration method of calibrating a test instrument (12), the test instrument (12) comprising at least one port (14, 16), at least one signal analysis module (20), and at least one signal generator module (18), wherein the at least one signal analysis module (20) and the at least one signal generator module (18) are each connected to the at least one port (14, 16), wherein the calibration method comprises the steps of

    - consecutively connecting a set of calibration standards to the at least one port and performing a calibration measurement for each calibration standard (34, 36, 38) connected, thereby obtaining a first set of measurement data;
    - determining, based on a multi-port error model and the first set of measurement data, a plurality of error terms of the multi-port error model, wherein the error terms describe transmissivity and reflectivity properties of at least the at least one port (14, 16), and wherein at least one of the error terms comprises a product of two error parameters;
    - connecting an additional calibration standard (40) to the at least one port (14, 16), wherein the additional calibration standard (40) is a signal source with known properties or a signal sink with known properties;
    - performing a calibration measurement with the additional calibration standard (40) connected, thereby obtaining a second set of measurement data; and
    - determining the two error parameters based on the second set of measurement data.

2. The calibration method of claim 1, wherein the calibration standards are connected to the at least one port (14, 16) at a reference plane (46).

3. The calibration method of claim 2, wherein a cable is connected to the at least one port (14, 16), and wherein the reference plane (46) is located at an end of the cable facing away from the at least one port (14, 16).

4. The calibration method according to any one of the preceding claims, wherein the product of two error parameters comprises a first error parameter and a second error parameter, wherein the first error parameter is determined directly based on the second set of measurement data, and wherein the second error parameter is calculated based on the determined product of the two error parameters and based on the first error parameter.

5. The calibration method according to any one of the preceding claims, wherein a mismatch of the additional calibration standard (40) is corrected based on the first set of measurement data.

6. The calibration method according to any one of the preceding claims, wherein the test instrument (12) comprises at least one directional coupler (22, 24), and wherein the at least one signal analysis module (20) and the at least one signal generator module (18) are connected to the at least one port (14, 16) by the at least one directional coupler (22, 24).

7. The calibration method according to any one of the preceding claims, wherein the multi-port error model is an n-term error model, particularly a four-term error model.

8. The calibration method according to any one of the preceding claims, wherein the multi-port error model is a two-port error model.

9. The calibration method according to any one of the preceding claims, wherein exactly one port of the test instrument (12) is calibrated at a time.

10. The calibration method according to any one of the preceding claims, wherein the additional calibration standard (40) is established as a signal generator, a comb generator, an oscilloscope, or an analog-to-digital converter.

11. The calibration method according to any one of the preceding claims, wherein the individual calibration standards (34, 36, 38) of the set of calibration standards are provided in a calibration device (28) having a housing (30), wherein the calibration device (28) further comprises a switching module (42) and a connecting port (32), and wherein the switching module (42) is configured to selectively connect one of the calibration standards (34, 36, 38) to the connecting port (32).

12. The calibration method of claim 11, wherein the additional calibration standard (40) is provided in the housing (30).

13. The calibration method according to claim 11, wherein the additional calibration standard (40) is provided separately from the calibration device (28), wherein the calibration device (28) comprises a further connecting port (44), wherein the switching module (42) is configured to selectively connect one of the calibration standards (34, 36, 38) or the further connecting port (44) to the connecting port (32).

14. The calibration method according to any one of the preceding claims, wherein the test instrument (12) is a vector network analyzer, a signal generator, particularly a vector signal generator, or a signal analyzer, particularly a vector signal analyzer.

15. A calibration system, the calibration system (10) comprising a test instrument (12), a set of calibration standards, and an additional calibration standard (40), wherein the calibration system (10) is configured to perform the calibration method according to any one of the preceding claims.

**Patentansprüche**

1. Kalibrierverfahren zum Kalibrieren eines Prüfgeräts (12), wobei das Prüfgerät (12) mindestens einen Anschluss (14, 16), mindestens ein Signalanalysemodul (20) und mindestens ein Signalgeneratormodul (18) umfasst, wobei das mindestens eine Signalanalysemodul (20) und das mindestens eine Signalgeneratormodul (18) jeweils mit dem mindestens einen Anschluss (14, 16) verbunden sind, wobei das Kalibrierverfahren die Schritte umfasst

- aufeinanderfolgendes Verbinden eines Satzes von Kalibrierstandards mit dem mindestens einen Anschluss und Durchführen einer Kalibriermessung für jeden verbundenen Kalibrierstandard (34, 36, 38), wodurch ein erster Satz von Messdaten erhalten wird;
- Bestimmen einer Vielzahl von Fehlertermen des Mehrfachanschluss-Fehlermodells basierend auf einem Mehrfachanschluss-Fehlermodell und dem ersten Satz von Messdaten, wobei die Fehlerterme die Transmissivitäts- und Reflektivitätseigenschaften von mindestens dem mindestens einen Anschluss (14, 16) beschreiben und wobei mindestens einer der Fehlerterme ein Produkt aus zwei Fehlerparametern umfasst;
- Verbinden eines zusätzlichen Kalibrierstandards (40) mit dem mindestens einen Anschluss (14, 16), wobei der zusätzliche Kalibrierstandard (40) eine Signalquelle mit bekannten Eigenschaften oder eine Signalsenke mit bekannten Eigenschaften ist;
- Durchführen einer Kalibriermessung mit dem verbundenen zusätzlichen Kalibrierstandard (40), wodurch ein zweiter Satz von Messdaten erhalten wird; und
- Bestimmen der zwei Fehlerparameter basierend auf dem zweiten Satz von Messdaten.

2. Kalibrierverfahren nach Anspruch 1, wobei die Kalibrierstandards mit dem mindestens einen Anschluss (14, 16) an einer Referenzebene (46) verbunden sind.

3. Kalibrierverfahren nach Anspruch 2, wobei ein Kabel mit dem mindestens einen Anschluss (14, 16) verbunden ist, und wobei sich die Referenzebene (46) an einem Ende des Kabels befindet, das dem mindestens einen Anschluss (14, 16) abgewandt ist.

4. Kalibrierverfahren nach einem der vorhergehenden Ansprüche, wobei das Produkt von zwei Fehlerparametern einen ersten Fehlerparameter und einen zweiten Fehlerparameter umfasst, wobei der erste Fehlerparameter direkt basierend auf dem zweiten Satz von Messdaten bestimmt wird, und wobei der zweite Fehlerparameter basierend auf dem bestimmten Produkt der zwei Fehlerparameter und basierend auf dem ersten Fehlerparameter berechnet wird.

5. Kalibrierverfahren nach einem der vorhergehenden Ansprüche, wobei eine Fehlanpassung des zusätzlichen Kalibrierstandards (40) basierend auf dem ersten Satz von Messdaten korrigiert wird.

6. Kalibrierverfahren nach einem der vorhergehenden Ansprüche, wobei das Prüfgerät (12) mindestens einen Richtkoppler (22, 24) umfasst, und wobei das mindestens eine Signalanalysemodul (20) und das mindestens eine Signalgeneratormodul (18) durch den mindestens einen Richtkoppler (22, 24) mit dem mindestens einen Anschluss (14, 16) ver-

**7.** Kalibrierverfahren nach einem der vorhergehenden Ansprüche, wobei das Mehrfachanschluss-Fehlermodell ein n-Term-Fehlermodell, insbesondere ein Vier-Term-Fehlermodell, ist.

**8.** Kalibrierverfahren nach einem der vorhergehenden Ansprüche, wobei das Mehrfachanschluss-Fehlermodell ein Zweifachanschluss-Fehlermodell ist.

**9.** Kalibrierverfahren nach einem der vorhergehenden Ansprüche, wobei jeweils genau ein Anschluss des Prüfgeräts (12) kalibriert wird.

**10.** Kalibrierverfahren nach einem der vorhergehenden Ansprüche, wobei der zusätzliche Kalibrierstandard (40) als Signalgenerator, Kammgenerator, Oszilloskop oder Analog-Digital-Wandler ausgebildet ist.

**11.** Kalibrierverfahren nach einem der vorhergehenden Ansprüche, wobei die einzelnen Kalibrierstandards (34, 36, 38) des Satzes von Kalibrierstandards in einer Kalibriervorrichtung (28) mit einem Gehäuse (30) bereitgestellt sind, wobei die Kalibriervorrichtung (28) ferner ein Schaltmodul (42) und einen Verbindungsanschluss (32) umfasst, und wobei das Schaltmodul (42) dazu konfiguriert ist, selektiv einen der Kalibrierstandards (34, 36, 38) mit dem Verbindungsanschluss (32) zu verbinden.

**12.** Kalibrierverfahren nach Anspruch 11, wobei der zusätzliche Kalibrierstandard (40) in dem Gehäuse (30) bereitgestellt ist.

**13.** Kalibrierverfahren nach Anspruch 11, wobei der zusätzliche Kalibrierstandard (40) getrennt von der Kalibriervorrichtung (28) bereitgestellt ist, wobei die Kalibriervorrichtung (28) einen weiteren Verbindungsanschluss (44) umfasst, wobei das Schaltmodul (42) konfiguriert ist, einen der Kalibrierstandards (34, 36, 38) oder den weiteren Verbindungsanschluss (44) selektiv mit dem Verbindungsanschluss (32) zu verbinden.

**14.** Kalibrierverfahren nach einem der vorhergehenden Ansprüche, wobei das Prüfgerät (12) ein Vektornetzwerkanalysator, ein Signalgenerator, insbesondere ein Vektorsignalgenerator, oder ein Signalanalysator, insbesondere ein Vektorsignalanalysator, ist.

**15.** Kalibriersystem, wobei das Kalibriersystem (10) ein Prüfgerät (12), einen Satz von Kalibrierstandards und einen zusätzlichen Kalibrierstandard (40) umfasst, wobei das Kalibriersystem (10) konfiguriert ist, das Kalibrierverfahren nach einem der vorhergehenden Ansprüche durchzuführen.

**Revendications**

**1.** Procédé d'étalonnage d'un instrument d'essai (12), l'instrument d'essai (12) comprenant au moins un port (14, 16), au moins un module d'analyse de signal (20), et au moins un module générateur de signal (18), dans lequel l'au moins un module d'analyse de signal (20) et l'au moins un module générateur de signal (18) sont chacun connectés à l'au moins un port (14, 16), dans lequel le procédé d'étalonnage comprend les étapes consistant à

- connecter consécutivement un ensemble de normes d'étalonnage à l'au moins un port et réaliser une mesure d'étalonnage pour chaque norme d'étalonnage (34, 36, 38) connectée, ce qui permet d'obtenir un premier ensemble de données de mesure ;
- déterminer, en fonction d'un modèle d'erreur multiport et du premier ensemble de données de mesure, une pluralité de termes d'erreur du modèle d'erreur multiport, les termes d'erreur décrivant des propriétés de transmissivité et de réflectivité d'au moins l'au moins un port (14, 16), et au moins l'un des termes d'erreur comprenant un produit de deux paramètres d'erreur ;
- connecter une norme d'étalonnage supplémentaire (40) à l'au moins un port (14, 16), la norme d'étalonnage supplémentaire (40) étant une source de signal avec des propriétés connues ou un puits de signal avec des propriétés connues ;
- réaliser une mesure d'étalonnage avec la norme d'étalonnage supplémentaire (40) connectée, ce qui permet d'obtenir un second ensemble de données de mesure ; et
- déterminer les deux paramètres d'erreur en fonction du second ensemble de données de mesure.

**2.** Procédé d'étalonnage selon la revendication 1, dans lequel les normes d'étalonnage sont connectées à l'au moins un port (14, 16) au niveau d'un plan de référence (46).

**3.** Procédé d'étalonnage selon la revendication 2, dans lequel un câble est connecté à l'au moins un port (14, 16), et dans lequel le plan de référence (46) est situé au niveau d'une extrémité du câble orientée à l'opposé de l'au moins un port (14, 16).

**4.** Procédé d'étalonnage selon l'une quelconque des revendications précédentes, dans lequel le produit de deux paramètres d'erreur comprend un premier paramètre d'erreur et un second paramètre d'erreur, dans lequel le premier paramètre d'erreur est déterminé directement en fonction du second ensemble de données de mesure, et dans lequel le second paramètre d'erreur est calculé en fonction du produit déterminé des deux paramètres d'erreur et en fonction du premier paramètre d'erreur.

5. Procédé d'étalonnage selon l'une quelconque des revendications précédentes, dans lequel une inadéquation de la norme d'étalonnage supplémentaire (40) est corrigée en fonction du premier ensemble de données de mesure.

6. Procédé d'étalonnage selon l'une quelconque des revendications précédentes, dans lequel l'instrument d'essai (12) comprend au moins un coupleur directionnel (22, 24), et dans lequel l'au moins un module d'analyse de signal (20) et l'au moins un module générateur de signal (18) sont connectés à l'au moins un port (14, 16) par l'au moins un coupleur directionnel (22, 24).

7. Procédé d'étalonnage selon l'une quelconque des revendications précédentes, dans lequel le modèle d'erreur multiport est un modèle d'erreur à n termes, en particulier un modèle d'erreur à quatre termes.

8. Procédé d'étalonnage selon l'une quelconque des revendications précédentes, dans lequel le modèle d'erreur multiport est un modèle d'erreur à deux ports.

9. Procédé d'étalonnage selon l'une quelconque des revendications précédentes, dans lequel exactement un port de l'instrument d'essai (12) est étalonné à la fois.

10. Procédé d'étalonnage selon l'une quelconque des revendications précédentes, dans lequel la norme d'étalonnage supplémentaire (40) est établie en tant que générateur de signal, générateur de peigne, oscilloscope, ou convertisseur d'analogique à numérique.

11. Procédé d'étalonnage selon l'une quelconque des revendications précédentes, dans lequel les normes d'étalonnage individuelles (34, 36, 38) de l'ensemble de normes d'étalonnage sont fournies dans un dispositif d'étalonnage (28) ayant un boîtier (30), dans lequel le dispositif d'étalonnage (28) comprend en outre un module de commutation (42) et un port de connexion (32), et dans lequel le module de commutation (42) est configuré pour connecter sélectivement l'une des normes d'étalonnage (34, 36, 38) au port de connexion (32).

12. Procédé d'étalonnage selon la revendication 11, dans lequel la norme d'étalonnage supplémentaire (40) est fournie dans le boîtier (30).

13. Procédé d'étalonnage selon la revendication 11, dans lequel la norme d'étalonnage supplémentaire (40) est fournie séparément à partir du dispositif d'étalonnage (28), dans lequel le dispositif d'étalonnage (28) comprend un autre port de connexion (44), dans lequel le module de commutation (42) est configuré pour connecter sélectivement l'une des normes d'étalonnage (34, 36, 38) ou l'autre port de connexion (44) au port de connexion (32).

14. Procédé d'étalonnage selon l'une quelconque des revendications précédentes, dans lequel l'instrument d'essai (12) est un analyseur de réseau vectoriel, un générateur de signal, en particulier un générateur de signal vectoriel, ou un analyseur de signal, en particulier un analyseur de signal vectoriel.

15. Système d'étalonnage, le système d'étalonnage (10) comprenant un instrument d'essai (12), un ensemble de normes d'étalonnage, et une norme d'étalonnage supplémentaire (40), dans lequel le système d'étalonnage (10) est configuré pour réaliser le procédé d'étalonnage selon l'une quelconque des revendications précédentes.

**Fig. 1**

# Fig. 2

# Fig. 3

S1 — | provide test instrument |

S2 — | provide calibration device |

S3 — | connect calibration standards to port of test instrument and perform calibration measurements |

S4 — | determine error terms |

S5 — | connect additional calibration standard to test instrument and perform calibration measurement |

S6 — | determine error parameters |

S7 — | adapt operational parameters of the test instrument |

S8 — | repeat steps S3 to S7 for further port(s) |

# Fig. 4

# Fig. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2017160369 A1